# EUROPEAN PATENT APPLICATION

(11) **EP 2 194 645 A2**
(43) Date of publication of application: **09.06.2010**
(21) Application number: 09172282.7
(22) Date of filing: 06.10.2009
(51) Int. Cl.: H03K 3/03, H03K 3/0231

(54) **Low-power relaxation oscillator and RFID tag using the same**

(30) Priority: 04.12.2008 KR 20080122210; 02.04.2009 KR 20090028376
(71) Applicant: Electronics and Telecommunications Research Institute, Daejeon 305-700 (KR)
(72) Inventor: Kang, Tae Young, 140-032 Seoul (KR); Park, Kyung Hwan, 305-755 Daejeon (KR); Hyun, Seok Bong, 305-755 Daejeon (KR); Kang, Tae Wook, 305-350 Daejeon (KR); Kim, Kyung Soo, 302-120 Daejeon (KR); Kim, Sung Eun, 138-170 Seoul (KR); Kim, Jung Bum, 305-500 Daejeon (KR); Myoung, Hey Jin, 305-350 Daejeon (KR); Park, Hyung II, 305-761 Daejeon (KR); Lim, In Gi, 305-768 Daejeon (KR); Choi, Byoung Gun, 706-746 Daegu (KR); Hyoung, Chang Hee, 305-770 Daejeon (KR); Hwang, Jung Hwan, 305-358 Daejeon (KR); Kang, Sung Weon, 305-340 Daejeon (KR)
(74) Representative: Betten & Resch

(57) **Abstract**

There is provided a low-power relaxation oscillator (100). The low-power relaxation oscillator may include: a constant current generation unit (110) generating a current having a predetermined magnitude; a current varying unit (120) controlling the current generated from the constant current generation unit according to a clock control signal (CT1,CT2,CT3,CT4) to output the controlled current; a first controller (131) and a second controller (132) connected in parallel with output terminals of the current varying unit and passing or interrupting the current supplied from the current varying unit; a PMOS charging/discharging unit (140) arranged between an output terminal of the first controller (N1) and an output terminal of the second controller (N2); a first comparator (151) and a second comparator (152) connected to both ends of the PMOS charging/discharging unit (140), respectively, and each outputting a high or low level voltage upon receiving voltage charged in the PMOS charging/discharging unit (140); and a latch circuit (160) delaying the voltages output from the first and second comparators to output, oscillation signals (V₀₁,V₀₂).

## Description

### CROSS-REFERENCE TO RELATED APPLICATIONS

This application claims the priorities of Korean Patent Application Nos. 2008-122210 filed on December 4, 2008, and 2009-0028376 filed on April 2, 2009, in the Korean Intellectual Property Office, the disclosures of which are incorporated herein by reference.

### BACKGROUND OF THE INVENTION

### Field of the Invention

The present invention relates to low-power relaxation oscillators and RFID tags using the same, and more particularly, to a low-power relaxation oscillator and an RFID tag that can correct changes in output frequency caused by the external environment.

### Description of the Related Art

In general, oscillators can be used as signal generating circuits in the field of electronic circuits. That is, oscillators generate signals that are stable against changes in time and vary periodically. These signals are used as system clock signals to control the timing of a system or as carrier signals (modulation signals) to convert the amplitude or frequency of signals.

These oscillators may be categorized into tuned oscillators and relaxation oscillators, which are called charge-discharge oscillators, according to the implementation method.

In particular, a relaxation oscillator generates an oscillation signal by charging and discharging a capacitor which is a kind of energy storage device within a range of a threshold voltage determined in a circuit. The relaxation oscillator repeatedly charges the capacitor and suddenly discharges the capacitor when voltage across the capacitor reaches a predetermined threshold voltage level, thereby outputting an oscillation frequency whose period is determined according to the charge and discharge time. This relaxation oscillator can be used as a low-power oscillator that supplies an operation clock to maintain synchronization between systems in a power-down mode of mobile communications system.

A tuned oscillator can operate at low power but is difficult to satisfy a 50% duty ratio since chips have different PMOS and NMOS characteristics, while a relaxation oscillator has a 50% duty ratio but increases manufacturing costs due to the use of a metal-insulator-metal (MIM) I capacitor.

### SUMMARY OF THE INVENTION

An aspect of the present invention provides a low-power relaxation oscillator that has a 50% duty ratio and can correct changes in output frequency caused by the external environment and an RFID tag using the same.

According to an aspect of the present invention, there is provided a low-power relaxation oscillator including: a constant current generation unit generating a current having a predetermined magnitude; a current varying unit controlling the current generated from the constant current generation unit according to a clock control signal to output the controlled current; a first controller and a second controller connected in parallel with output terminals of the current varying unit and passing or interrupting the current supplied from the current varying unit; a PMOS charging/discharging unit arranged between an output terminal of the first controller and an output terminal of the second controller; a first comparator and a second comparator connected to both ends of the PMOS charging/discharging unit, respectively, and each outputting a high or low level voltage upon receiving voltages charged in the PMOS charging/discharging unit; and a latch circuit delaying the voltages output from the first and second comparators to output oscillation signals.

The PMOS charging/discharging unit may include: a first PMOS capacitor; and a second PMOS capacitor, wherein the first PMOS capacitor and the second PMOS capacitor have gates and drains cross-coupled to each other.

The current varying unit may include: a fixed transistor passing the current generated from the constant current generation unit so that the relaxation oscillator outputs a minimum oscillation frequency; and a variable transistor connected in parallel with the fixed transistor and controlling the current from the constant current generation unit according to a digital clock control signal so as to control an output frequency of the relaxation oscillator.

The variable transistor may include first through fourth variable transistors controlling the current by using 4-bit digital clock control signals.

The first controller and the second controller may be respectively connected to output terminals of the latch circuit, and pass or interrupt the current supplied from the current varying unit according to voltage fed back from the latch circuit.

The first comparator and the second comparator may be Schmitt triggers.

According to another aspect of the present invention, there is provided an RFID tag including: a clock generation unit; and a digital unit supplying a clock control signal to control an output frequency of the clock generation unit, wherein the clock generation unit may include: a constant current generation unit generating a current having a predetermined magnitude; a current varying unit controlling the current generated from the constant current generation unit according to a clock control signal to output the controlled current; a first controller and a second controller connected in parallel with output terminals of the current varying unit and passing or interrupting the current supplied from the current varying unit; a PMOS charging/discharging unit arranged between an output terminal of the first controller and an output terminals of the second controller; a first comparator and a second comparator connected to both ends of the PMOS charging/discharging unit, respectively, and each outputting a high or low level voltage upon receiving voltage charged in the PMOS charging/discharging unit; and a latch circuit delaying the voltages output from the first and second comparators to output oscillation signals.

The digital unit may include: a counter counting a clock output from the clock generation unit; a comparator comparing a clock number counted by the counter with a predetermined clock number; and a clock controller supplying a clock control signal to the clock generation unit to compensate a clock frequency with respect to a difference in clock numbers compared by the comparator.

The current varying unit may include: a fixed transistor passing the current from the constant current generation unit so that the relaxation oscillator outputs a minimum oscillation frequency; and a variable transistor connected in parallel with the fixed transistor and controlling the current according to a digital clock control signal so as to control an output frequency of the relaxation oscillator.

The variable transistor may include first through fourth variable transistors controlling the current according to 4-bit digital clock control signals, respectively.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a view illustrating the configuration of a low-power relaxation oscillator according to an exemplary embodiment of the present invention;

FIG. 2 is a view illustrating the configuration of an RFID tag according to another exemplary embodiment of the present invention;

FIG. 3 is a flow chart illustrating a method of compensating an output frequency of a clock generation unit of the RFID tag according to the embodiment, shown in FIG. 2; and

FIG. 4 is a view illustrating an example of the operation of the counter of the RFID tag according to the embodiment, shown in FIG. 2.

### DETAILED DESCRIBTION OF THE PREFZRRED EMBODIMENT

Exemplary embodiments of the present invention will now be described in detail with reference to the accompanying drawings.

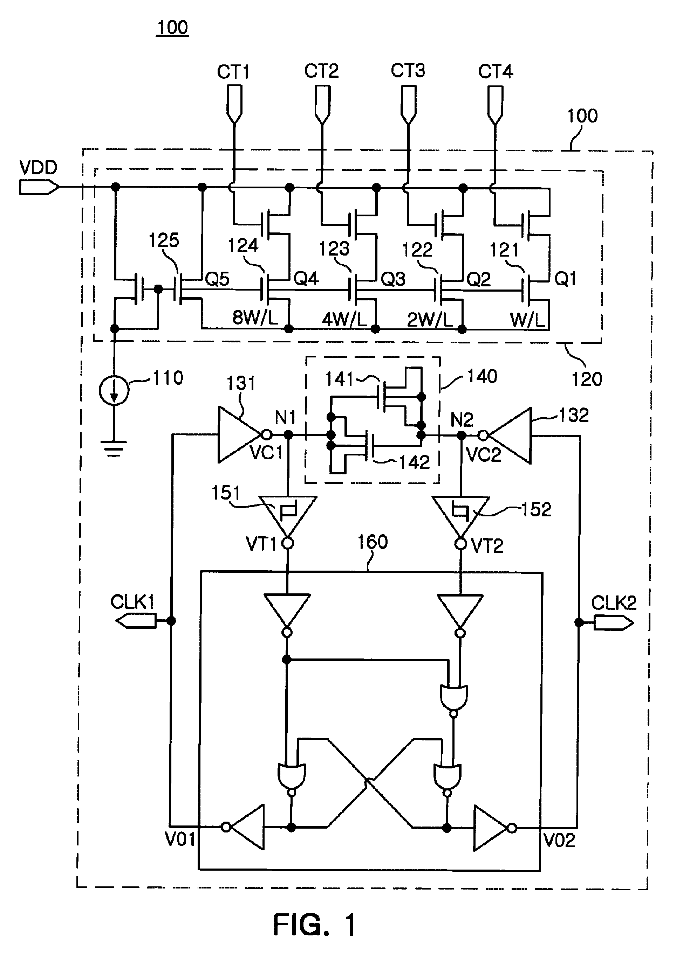

FIG. 1 is a view illustrating the configuration of a low-voltage relaxation oscillator 100 according to an exemplary embodiment of the invention.

Referring to FIG. 1, a low-voltage relaxation oscillator 100 according to this embodiment may include a constant current generation unit 110, a current varying unit 120, first and second controllers 131 and 1.2,a PMOS charging/discharging unit 140, first and second comparators 151 and 152 and a latch circuit 160.

The constant current generation unit 110 may be a current source that generates a current.

The current varying unit 120 may control and output the current, generated by the constant current generation unit 110, according to a clock control signals.

In this embodiment, the current varying unit 120 may include a fixed transistor 125 and a variable transistor. The fixed transistors 125 passes the current generated by the constant current generation unit 110 so that the relaxation oscillators oscillates the minimum oscillation frequency. The variable transistor is connected in parallel with the fixed transistor 125 and controls the current generated by the constant current generation unit 110 according to a digital clock control signal so as to control the oscillation frequency of the relaxation oscillator. In this embodiment, the variable transistor may include first, second, third and fourth transistors 121, 122, 123 and 124, each of which controls a current according to a 4-bit digital clock control signal.

Even when the first, second, third and fourth transistors 121, 122, 123 and 124 are turned off, the fixed transistor 125 passes a default current so that the oscillator can perform oscillation. At this time, the frequency of the oscillator may become the minimum oscillation frequency.

An output frequency of the oscillator that is actually used may be different from that of the oscillator in design due to temperature and process variations. In this embodiment, in order to correct the difference between the output frequency in the actual environment and the output frequency in design, the first, second, third and fourth transistors 121, 122, 123 and 124 that can be turned on/off may be used. The first, second, third and fourth transistors 121, 122, 123 and 124 are controlled according to 4-bit signals CT1, CT2, CT3 and CT4, respectively, thereby controlling the output frequency of the oscillator.

The first controller 131 and the second controller 132 are connected in parallel with the current varying unit 120 and may pass or interrupt the current supplied from the current varying unit 120. In this embodiment, the first controller 131 and the second controller 132 may be inverters.

In this embodiment, a clock signal output from the relaxation oscillator is fed back to each of the first controller 131 and the second controller 132, which may then pass or interrupt the current supplied from the current varying unit 120 according to the clock signal.

The PMOS charging/discharging unit 140 is connected between an output terminal of the first controller 131 and an output terminal of the second controller 132 and charges or discharges voltage according to an output voltage of the first controller 131 and an output voltage of the second controller 132.

In this embodiment, the PMOS charging/discharging unit 140 may include a first PMOS capacitor 141 and a second PMOS capacitor 142. The first PMOS capacitor 141 and the second PMOS capacitor 142 may have gates and drains cross-coupled to each other. That is, a gate of the first PMOS capacitor 141 may be coupled to a source and a drain of the second PMOS capacitor 142 and thus be connected to the output terminal of the first controller 131, while a gate of the second PMOS capacitor 142 may be coupled to a drain and a source of the first PMOS capacitor 141 and thus be connected to the output terminal of the second controller 132.

Each of the first and second PMOS capacitors 141 and 142 has variable capacitance according to voltage at both ends thereof. Therefore, even though a voltage rise slope changes over time during voltage rise at a node 1 N1 and a node 2 N2, that is, both terminals of the PMOS charging/discharging unit, since the two nodes have the same operating characteristics, the output frequency can maintain a duty ratio of 50%.

The first and second comparators 151. and 152 are connected to both terminals of the PMOS charging/discharging unit 140, respectively, and receive the voltage charged in the PMOS charging/discharging unit 140 to output a high-level voltage or a low-level voltage .

In this embodiment, the first and second comparators 151 and 152 may be Schmitt triggers. The Schmitt trigger is a circuit that operates rapidly when input amplitude exceeds a predetermined threshold value, thereby gaining a neatly constant output, and is immediately restored when input amplitude is less than the predetermined threshold value.

The latch circuit 160 delays the voltages output from the first and second comparators 151 and 152 to output oscillation signals.

The operation of the relaxation oscillator 100 according to this embodiment will now be described.

When an output voltage V_{O1} is at a level L (low) and an output voltage V_{O2} is at a level H (high), the first controller 131 may pass the current from the current source, while the second controller 132 may interrupt the current from the current source. Therefore, a voltage V_{C2} applied at one terminal of the PMOS charging/discharging unit 140 become 0, and the current flowing through the PMOS charging/discharging unit 140 has a positive (+) value, so that a voltage Vc between both ends of the capacitor may gradually increase. Here, since the voltage Vc₂ becomes 0 and the voltage V_{C1} becomes the voltage Vc, the voltage V_{C1} may increase over time. When the voltage V_{C1} gradually increases and reaches a threshold value V_{LTH} of the Schmitt triggers 151 and 152, output voltages V_{T1} and V_{T2} of the Schmitt triggers change from (V_{T1}, V_{T2}) = (H, H) to (V_{T1}, V_{T2}) = (L, H). Here, the levels L and H of the voltages V_{O1} and V_{O2} may become levels H and L, respectively.

Then, the first controller 131 may be turned off and the second controller 132 may be turned on so that the voltage V_{C1} may become 0 and the voltage V_{C2} may become - Vc. Here, since the voltages V_{C1} and V_{C2} are less than the threshold value V_{LTH}, the output voltages V_{T1} and V_{T2} become at levels H (high). As a result, the output voltages V_{O1} and V_{O2} can maintain the state of (V_{O1}, V_{O2}) = (H, L). When the voltage V_{C2} continues to increase and finally reaches the threshold value V_{LTH}. (V_{T1}, V_{T2}) = (H, L) its satisfied, and the levels of the voltages V_{O1} and V_{O2} switch with each other to satisfy (V_{O1}, V_{O2}) = (L, H). The above-described process is then repeated so that a clock signal having a duty ratio of 50% can be generated.

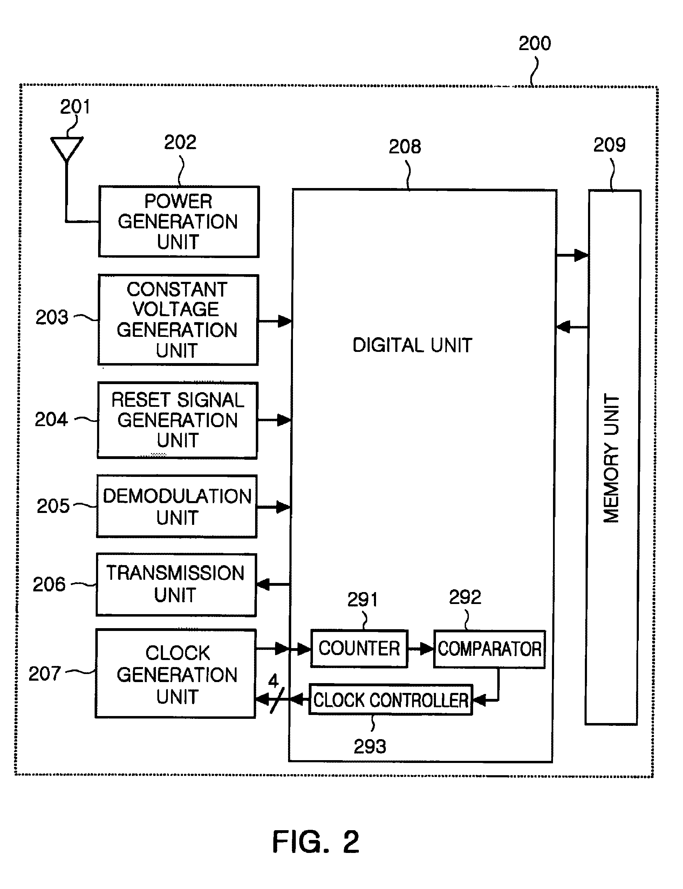

FIG. 2 is a view illustrating the configuration of an RFID tag according to another exemplary embodiment of the invention .

Referring to FIG. 2, an RFID tag 200 according to this embodiment may include a power veneration unit 202, a constant voltage generation unit 203, a reset signal generation unit 204, a demodulation unit 205, a transmission unit 206, a clock generation unit 207, a digital unit 208 and a memory unit 209.

The power generation unit 202 may generate DC power by using a signal received from an antenna, and the constant voltage generation unit 203 may supply a predetermined constant voltage to the digital unit 208 and the memory unit 209 using the output from the power generation unit 202. The reset signal generation unit 204 may supply to the digital unit 208, a power-on signal when a high power voltage enough to operate the RFID tag is generated and a reset signal when power voltage drops to a low level. The demodulation unit 205 may detect a command from an input signal and transmit the command to the digital unit 208. The transmission unit 206 may change the impedance of a tag chip in order to transit information to an RFID reader.

The clock generation unit 207 may start to generate a clock at the same time as the RFID tag starts at power up, and transmit the clock to the digital unit 208. In this embodiment, the clock generation unit 207 may be the above-described low-power relaxation oscillator, shown in FIG. 1.

The digital unit 208 may supply a clock control signal to the clock generation unit 207 so as to control the output frequency of the clock generation unit 207. In this embodiment, the digital unit 208 may include a counter 291, a comparator 292 and a clock controller 293.

The counter 291 may count the clock that is output from the clock generation unit 207. The comparator 292 may compare a clock number counted by the counter with a predetermined clock numbers. The clock controller 293 may supply a clock control signal to the clock generation unit 207 so as to compensate frequency that is output from the clock generation unit 207 by the difference in clock numbers compared by the comparator 292.

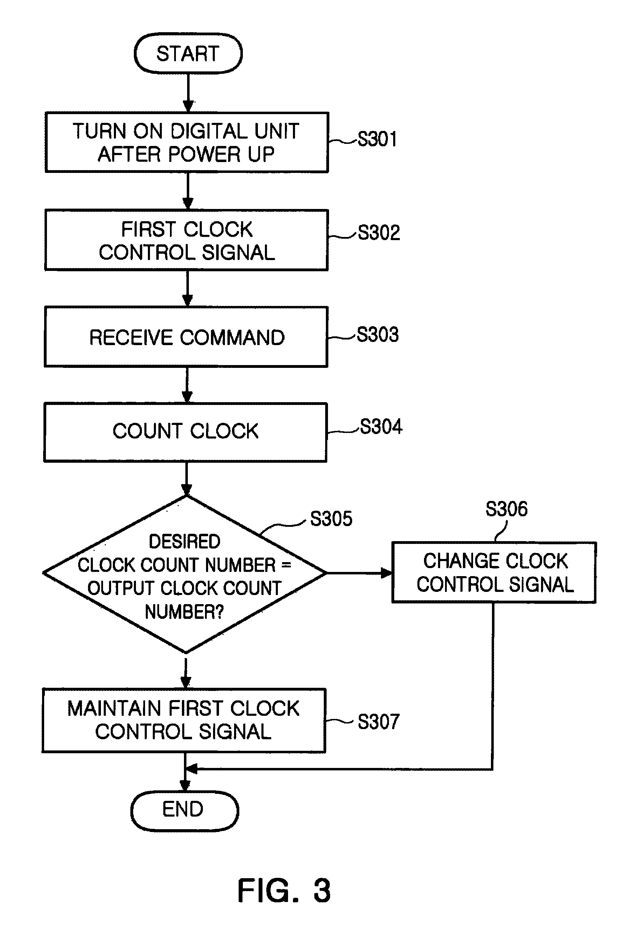

FIG. 3 is a flow chart illustrating a method of compensating the frequency of the clock that is output from the clock generation unit through the operations of the clock generation unit 207 and the digital unit 208 in the RAID tag according to the embodiment, shown in FIG. 2.

In this embodiment, the digital unit 208 may generate a signal that is a 4-bit binary code to control the clock generation unit 207. Here, when a frequency of 40 KHz is controlled by 1 bit, a controllable frequency range reaches 640 KHz, and the oscillation frequency may be within the range of 1.92MHz ± 320 KHz when designing the clock generation unit 207. The minimum oscillation frequency at which the clock generation unit 207 receives power and starts to operate may be 1.6 MHz . A desired output frequency of the RFID tag may be 1.92 MHz.

An order in which the output frequency of the clock generation unit is compensated will be described with reference to FIGS. 2 and 3.

First, when the power generation unit 202 of the RFID tag generates sufficient power, the reset signal generation unit 204 transmits a power-on signal to the digital unit 208 so that the digital unit 208 can be in an ON state in operation S301.

When the digital unit 208 is in the ON state, the clock controller 293 may supply a 4-bit control signal (1000) as a first clock control signal to the clock generation unit 207 so that the clock controller 293 outputs a frequency of 1.92 MHz in operation S302. However, since the output frequency of the clock generation unit 207 may vary due to temperature and process variations, the clock generation unit 207 may output a different frequency from the desired output frequency.

When the digital unit 208 receives the command from the RAID reader in operation S303, the counter 291 may count the clock, output from the clock generation unit 207, for a predetermined period of time in operation S304.

The comparator 292 may compare a clock number counted by the counter 291 and a desired clock count number in operation S305 and then transmit a comparison value to the clock controller 293. The desired clock count number may be a clock count number calculated on the basis of frequency that the clock generation unit 207 needs to output.

The clock controller 293 may supply a clock control signal to the clock generation unit 207 according to the result of the comparator 292 so that the frequency currently being output from the clock generation unit is changed into the desired outputs frequency. For example, when the desired output frequency is 1.92 MHz according to the 4-bit control signal (1000), which is the first clock control signal, and the clock generation unit 207 actually generates a frequency of 1.8 MHz, in order to correct the difference of 120 KHz, the clock controller 293 may change the 4-bit control code being supplied to the clock generation unit 207 into 1011 in operation S306.

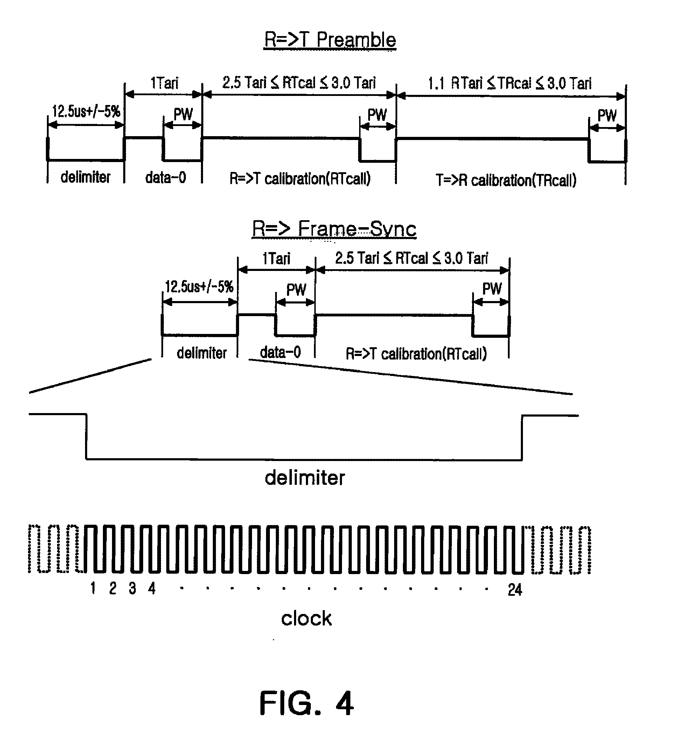

FIG. 4 is a view illustrating an example of the operation of the counter of the RFID tag according to the embodiment, shown in Fig. 2.

Referring to FIG. 4, the command, transmitted to the RFID tag from the RFID reader, may be divided into a preamble and a frame-sync. Each of the commands begins with a delimiter that maintains a low level for 12.5 µs, and for this time, the counter of the digital unit may count the clock. When the counter counts a clock with a frequency of 1.92 MHz for 12.5 µs, a count number may become 12.5/(1/1.92) = 24. When the count number is 23, the frequency may become 1.84 MHz. When the count number is 25, the frequency may become 2.0 MHz. That is, in this embodiment, when a difference in clock frequencies is 80 KHz, count numbers may differ by one.

As set forth above, according to exemplary embodiments of the invention, there can be provided a low-power relaxation oscillation that can maintain a 50% duty ratio and correct changes in output frequency caused by the external environment and an RFID tag using the same.

While the present invention has been shown and described in connection with the exemplary embodiments, it will be apparent to those skilled in the art that modifications and variations can be made without departing from the spirit and scope of the invention as defined by the appended claims.

## Claims

1. A low-power relaxation oscillator comprising:
a constant current generation unit generating a current having a predetermined magnitude;
a current varying unit controlling the current generated from the constant current generation unit according to a clock control signal to output the controlled current;
a first controller and a second controller connected in parallel with output terminals of the current varying unit and passing or interrupting the current supplied from the current varying unit;
a PMOS charging/discharging unit arranged between an output terminal of the first controller and an output terminal of then second controller;
a first comparator and a second comparator connected to both ends of the PMOS charging/discharging unit, respectively, and each outputting a high or low level voltage upon receiving voltage charged in the PMOS charging/discharging unit; and
a latch circuit delaying the voltages output from the first and second comparators to output oscillation signals.

2. The low-power relaxation oscillator of claim 1, wherein the PMOS charging/discharging unit comprises :
a first PMOS capacitor; and
a second PMOS capacitor,
wherein the first PMOS capacitor and the second PMOS capacitor have gates and drains cross-coupled to each other.

3. The low-power relaxation oscillator of claim 1 or 2, wherein the current varying unit comprises:
a fixed transistor passing the current generated from the constant current generation unit so that the relaxation oscillator outputs a minimum oscillation frequency; and
a variable transistor connected in parallel with the fixed transistor and controlling the current from the constant current generation unit according to a digital clock control signal so as to control an output frequency of the relaxation oscillator,

4. The low-power relaxation oscillator of claim 3, wherein the variable transistor comprises first through fourth variable transistors controlling the current by using 4-bit digital clock control signals.

5. The low-power relaxation oscillator of one of claims 1 to 4, wherein the first controller and the second controller are respectively connected to output terminals of the latch circuit, and pass or interrupt the current supplied from the current varying unit according to voltage fed back from the latch circuit.

6. The low-power relaxation oscillator of one of claims 1 to 5, wherein the first comparator and the second comparator are Schmitt triggers.

7. An RFID tag comprising:
a clock generation unit; and
a digital unit supplying a clock control signal to control an output frequency of the clock generation unit,
wherein the clock generation unit comprises:
a constant current generation unit generating a current having a predetermined magnitude;
a current varying unit controlling the current generated from the constant current generation unit according to a clock control signal to output the controlled current;
a first controller and a second controller connected in parallel with output terminals of the current varying unit and passing or interrupting the current supplied from the current varying unit;
a PMOS charging/discharging unit arranged between an output terminal of the first controller and an output terminal of the second controller;
a first comparator and a second comparator connected to both ends of the PMOS charging/discharging unit, respectively, and each outputting a high or low level voltage upon receiving voltage charged in the PMOS charging/discharging unit; and
a latch circuit delaying the voltages output from each of the first and second comparators to output oscillation signals.

8. The RFID tag of claim 7, wherein the digital unit comprises:
a counter counting a clock output from the clock generation unit;
a comparator comparing a clock number counted by the counter with a predetermined clock number; and
a clock controller supplying a clock control signal to the clock generation unit to compensate a clock frequency with respect to a difference in clock numbers compared by the comparator,

9. The RFID tag of claim 7 or 8, wherein the current varying unit comprises:
a fixed transistor passing the current from the constant current generation unit so that the relaxation oscillator outputs a minimum oscillation frequency; and
a variable transistor connected in parallel with the fixed transistor and controlling the current according to a digital clock control signal so as to control an output frequency of the relaxation oscillator.

10. The RFID tag of claim 9, wherein the variable transistor comprises first through fourth variable transistors controlling the current according to 4-bit digital clock control signals, respectively.
